(19) **Europäisches Patentamt / European Patent Office / Office européen des brevets**

(11) **EP 4 620 931 A1**

(12) **EUROPEAN PATENT APPLICATION**
published in accordance with Art. 153(4) EPC

(43) Date of publication:
**24.09.2025 Bulletin 2025/39**

(21) Application number: **24848868.6**

(22) Date of filing: **11.07.2024**

(51) International Patent Classification (IPC):
$C03C\ 13/00$ (2006.01)    $B29B\ 15/08$ (2006.01)
$C03C\ 3/097$ (2006.01)    $H05K\ 1/03$ (2006.01)
$B29K\ 105/06$ (2006.01)

(52) Cooperative Patent Classification (CPC):
**B29B 15/08; C03C 3/097; C03C 13/00; H05K 1/03;**
B29K 2105/06

(86) International application number:
**PCT/JP2024/025082**

(87) International publication number:
**WO 2025/028210 (06.02.2025 Gazette 2025/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.07.2023 JP 2023123877**

(71) Applicant: **Nitto Boseki Co., Ltd.**
**Fukushima-shi,**
**Fukushima 960-8161 (JP)**

(72) Inventors:
- **HOSOKAWA, Takanobu**
 **Koriyama-shi, Fukushima 963-8061 (JP)**
- **NISHIKUBO, Ryo**
 **Koriyama-shi, Fukushima 963-8061 (JP)**
- **KURITA, Tadashi**
 **Koriyama-shi, Fukushima 963-8061 (JP)**

(74) Representative: **Schön, Christoph**
**Dr. Schön, Neymeyr & Partner mbB**
**Bavariaring 26**
**80336 München (DE)**

(54) **GLASS COMPOSITION FOR GLASS FIBERS, GLASS FIBER, GLASS FIBER WOVEN FABRIC, AND GLASS FIBER-REINFORCED RESIN COMPOSITION**

(57) Provided is a glass composition for glass fiber that can achieve both a high elastic modulus and a low coefficient of linear thermal expansion and that enables molten glass with excellent compositional uniformity and clarity. The glass composition for glass fiber of the present invention includes 42.00 to 70.00% by mass of $SiO_2$, 10.00 to 30.00% by mass of $Al_2O_3$, 0.00 to 8.00% by mass of MgO, 0.00 to 5.00% by mass of CaO, 2.00 to 25.00% by mass of ZnO, 0.00 to 5.00% by mass of $TiO_2$, 2.00 to 17.30% by mass of $P_2O_5$, and 0.01 to 2.00% by mass in total of MxOy (one or more oxides selected from $Fe_2O_3$, $SnO_2$, $CeO_2$, $MnO_2$, $Sb_2O_3$, and $As_2O_3$), with respect to the total amount, and the content Z of ZnO, the content P of $P_2O_5$, and the content M of MxOy satisfy the following formula (1):

$$0.088 \leq (Z/P) \times M^{1/2} \leq 3.554 \ldots (1).$$

EP 4 620 931 A1

**Description**

Technical Field

The present invention relates to a glass composition for glass fiber, glass fiber, a glass fiber woven fabric, and a glass fiber-reinforced resin composition.

Background Art

Conventionally, glass fiber has been widely used to improve the strength of resin compositions.

In recent years, as the electronic devices have become smaller and lighter, resin compositions in printed circuit boards and others used in the electronic devices are required to have high rigidity and excellent dimensional stability. Therefore, glass fiber used for reinforcing the resin compositions is also required to achieve both a high elastic modulus and a low coefficient of linear thermal expansion.

In order to achieve both a high elastic modulus and a low coefficient of linear thermal expansion of glass fiber, the present applicant has filed patent applications for glass compositions for glass fiber containing ZnO and $P_2O_5$ (Japanese Patent Application No. 2023-029848 and PCT/JP2023/014110).

Summary of Invention

Technical Problem

However, glass fiber obtained from the glass compositions for glass fiber described in Japanese Patent Application No. 2023-029848 and PCT/JP2023/014110, has a disadvantage that there occur variations in elastic modulus and coefficient of linear thermal expansion.

As a result of diligent examinations on the cause of the aforementioned disadvantage, the present inventors have found that, when the glass composition for glass fiber is melted to form molten glass, ZnO and $P_2O_5$ are difficult to be dissolved in the initial stage of melting, and thus insufficient stirring during the melting process causes a variation in compositional feature of the molten glass, and that the variation in compositional feature of the molten glass is significant in the glass composition for glass fiber containing both ZnO and $P_2O_5$, resulting in variations in elastic modulus and coefficient of linear thermal expansion of glass fiber obtained from the molten glass.

Note that the variation in compositional feature of the molten glass as used herein refers to a gradual compositional difference over the entire interior of the molten glass, and differs from defects, such as striae and phase separation, that locally produce a heterogeneous glass region or a heterogeneous glass phase that differs in compositional feature from the surrounding glass. The striae refer to striated regions of a few millimeters or less that have a glass compositional feature different from the surrounding glass compositional feature, and the phase separation refers to a phase separation phenomenon in which a single phase of molten glass forms glass phases of a few micrometers or less with different compositional features due to heat and other factors. Such a heterogeneous glass region or a different glass phase has a large difference in compositional feature from the surrounding glass and causes a difference in refractive index, and thus can be observed by the naked eye or by optical methods. However, in the glass compositions for glass fiber described in Japanese Patent Application No. 2023-029848 and PCT/JP2023/014110, no defects occur that can be seen by the naked eye or other methods, such as striae or phase separation.

That is, the aforementioned variation in molten glass compositional feature as used herein is discovered only through observation by the method described later, as a result of diligent examinations by the present inventors in order to eliminate the aforementioned disadvantage.

Here, as a means of stirring the molten glass during melting of the molten glass, it is considered to add a gas-generating component to the glass composition for glass fiber during melting of $Fe_2O_3$, $SnO_2$, $CeO_2$, $MnO_2$, $Sb_2O_3$, $As_2O_3$, and others. When the aforementioned component is added to the glass composition for glass fiber, the component generates gas during melting of the molten glass, the generated gas moves upward, and the effect of stirring the molten glass is thus expected.

On the other hand, when the aforementioned component generates gas during melting of the molten glass, the clarity of the molten glass is reduced and bubbles (hollows) are included in a glass filament constituting the glass fiber, resulting in a disadvantage that, when a glass fiber-reinforced resin composition using the glass fiber is used in a printed circuit board, it may cause the insulation reliability of the printed circuit board to be reduced.

Thus, an object of the present invention is, by eliminating such disadvantages, to provide a glass composition for glass fiber that enables glass fiber achieving both a high elastic modulus and a low coefficient of linear thermal expansion and that also enables molten glass with excellent compositional uniformity and clarity.

Solution to Problem

As a result of repeated examinations in order to achieve the object, the present inventors have found that by adjusting the contents of ZnO, $P_2O_5$, and MxOy (at least one or more oxides selected from the group consisting of $Fe_2O_3$, $SnO_2$, $CeO_2$, $MnO_2$, $Sb_2O_3$, and $As_2O_3$) in a glass composition for glass fiber with a specific compositional feature, it is possible to obtain glass fiber achieving both a high elastic modulus and a low coefficient of linear thermal expansion, and furthermore, it is possible to make the compositional feature of molten glass uniform and to reduce the amount of bubbles included in the molten glass, thereby increasing the clarity of the molten glass, and have arrived the present invention.

Thus, the glass composition for glass fiber of the present invention includes $SiO_2$ in the range of 42.00 to 70.00% by mass, $Al_2O_3$ in the range of 10.00 to 30.00% by mass, MgO in the range of 0.00 to 8.00% by mass, CaO in the range of 0.00 to 5.00% by mass, ZnO in the range of 2.00 to 25.00% by mass, $TiO_2$ in the range of 0.00 to 5.00% by mass, $P_2O_5$ in the range of 2.00 to 17.30% by mass, and MxOy (at least one or more oxides selected from the group consisting of $Fe_2O_3$, $SnO_2$, $CeO_2$, $MnO_2$, $Sb_2O_3$, and $As_2O_3$) in the range of 0.01 to 2.00% by mass in total, with respect to the total amount, and the content Z of ZnO, the content P of $P_2O_5$, and the content M of MxOy satisfy the following formula (1):

$$0.088 \leq (Z/P) \times M^{1/2} \leq 3.554 \ ... \ (1).$$

By including $SiO_2$, $Al_2O_3$, MgO, CaO, ZnO, $TiO_2$, $P_2O_5$, and MxOy in the respective ranges described above with respect to the total amount, the glass composition for glass fiber of the present invention enables glass fiber with a high elastic modulus and a low coefficient of linear thermal expansion.

Here, glass fiber with a high elastic modulus means that the elastic modulus of the glass fiber is 70.0 GPa or more, as measured by the following measurement method of elastic modulus, and glass fiber with a low coefficient of linear thermal expansion means that the coefficient of linear thermal expansion of the glass fiber is 3.0 ppm/K or less, as calculated by the following measurement method of linear thermal expansion coefficient.

[Measurement method of elastic modulus]

First, a glass batch adjusted to have the compositional feature of the glass composition for glass fiber is placed in an 80 mm diameter platinum crucible, melted by heating at a temperature of 1650°C for 6 hours, and then taken out of the platinum crucible to obtain homogeneous glass bulk or glass cullet. The obtained glass bulk or glass cullet is then annealed by heating at a temperature of 750°C for 8 hours to obtain a test piece. Next, the test piece is processed into a test piece for elastic modulus measurement of 50 mm $\times$ 50 mm $\times$ 5 mm using a cutting machine such as diamond cutter and a polisher, and using the test piece for elastic modulus measurement, the elastic modulus is measured by the ultrasonic pulse method according to JIS R 1602:1995.

[Measurement method of coefficient of linear thermal expansion]

First, a test piece obtained in the same manner as in the case of the elastic modulus measurement described above is processed into a test piece for coefficient of linear thermal expansion measurement of 4 mm $\times$ 4 mm $\times$ 20 mm using a cutting machine such as diamond cutter and a polisher. Next, the obtained test piece for coefficient of linear thermal expansion measurement is heated at a temperature increase rate of 10°C/min, and the amount of elongation is measured using a coefficient of thermal expansion measuring apparatus (manufactured by NETZSCH, trade name: DIL 402) at a temperature in the range of 50 to 200°C. From the amount of elongation, the coefficient of linear thermal expansion is calculated.

Also, by the glass composition for glass fiber of the present invention including $SiO_2$, $Al_2O_3$, MgO, CaO, ZnO, $TiO_2$, $P_2O_5$, and MxOy in the respective ranges described above with respect to the total amount, and the content Z of ZnO, the content P of $P_2O_5$, and the content M of MxOy satisfying the formula (1), when MxOy generates gas in the molten glass, the generated gas entraps minute bubbles existing in the molten glass to form large bubbles, and these large bubbles easily rise to the top of the molten glass and escape. As a result, the clarity of the molten glass can be increased and bubbles (hollows) included in glass fiber obtained from the glass composition for glass fiber can be reduced.

Here, the molten glass having high clarity means that the number of bubbles per 1 g of glass bulk, as measured by the following evaluation method of clarity, is 150 or more and less than 1,000.

[Evaluation method of clarity]

First, a glass batch adjusted to have the compositional feature of the glass composition for glass fiber is placed in an 80 mm diameter platinum crucible, melted at a temperature of 1600°C for 3 hours, and then taken out of the platinum crucible to obtain glass bulk. The obtained glass bulk is heated at a temperature of 750°C for 2 hours, and then annealed by cooling to room temperature over 8 hours to obtain a test piece. Next, the central part of the obtained test piece is cut out to a size of 10 mm × 15 mm using a cutting machine such as diamond cutter, and the surface is polished with #2000 abrasive paper. The number of bubbles included in the test piece whose surface has been polished is then measured using an optical microscope.

In addition, according to the glass composition for glass fiber of the present invention, when the large bubbles rise to the top of the molten glass, the molten glass is stirred, which can facilitate dissolution of $ZnO$ and $P_2O_5$, making the compositional feature of the molten glass uniform.

Here, the compositional feature of the molten glass being uniform means that the compositional uniformity is 10.0% or less, as calculated by the following evaluation method of compositional uniformity.

[Evaluation method of compositional uniformity]

First, the central part of a test piece obtained in the same manner as for the evaluation method of clarity is cut out to a size of 10 mm × 15 mm for the top and bottom surfaces using a cutting machine such as diamond cutter, and the sides are polished with #2000 abrasive paper. Next, for the sides of the test piece whose surface has been polished, compositional analysis is performed by the EDS (energy dispersive spectroscopy) to evaluate the difference in compositional feature between the top and bottom regions. Specifically, using a field emission scanning electron microscope (FE-SEM, manufactured by JEOL Ltd., model number: JSM-IT800) and an energy dispersive spectrometer (manufactured by JEOL Ltd., model number: EDS 30 mm$^2$ detector), an area measurement is performed for a region of 1 mm in height range from each of the top and bottom surfaces, with an arbitrary field of view of 100 μm$^2$ or more, to measure the content (%) in terms of oxide for each element included in the glass composition for glass fiber. Note that the measurement of the content in terms of oxide for the element is carried out in three different areas for each of the top and bottom regions, and the average value of the measurement results for the three areas is used as the content in terms of oxide for each element. For each element, the absolute value of the difference between the content in terms of oxide in the top region and the content in terms of oxide in the bottom region was calculated, and the calculation was performed for all elements detected. The value obtained by adding up the absolute values of the differences in content of all of the elements is used as the compositional uniformity. Note that a smaller value for the compositional uniformity means a smaller variation in compositional feature of the molten glass (excellent uniformity).

In addition, the glass composition for glass fiber of the present invention includes $SiO_2$, $Al_2O_3$, $MgO$, $CaO$, $ZnO$, $TiO_2$, $P_2O_5$, and MxOy in the respective ranges described above with respect to the total amount, and the content Z of $ZnO$, the content P of $P_2O_5$, and the content M of MxOy preferably satisfy the following formula (2):

$$0.183 \leq (Z/P) \times M^{1/2} \leq 1.775 \ ... \ (2).$$

By the glass composition for glass fiber of the present invention including $SiO_2$, $Al_2O_3$, $MgO$, $CaO$, $ZnO$, $TiO_2$, $P_2O_5$, and MxOy in the respective ranges described above with respect to the total amount, and the content Z of $ZnO$, the content P of $P_2O_5$, and the content M of MxOy satisfying the formula (2), it is possible to obtain glass fiber with a high elastic modulus and a low coefficient of linear thermal expansion, to make the compositional feature of the molten glass more uniform, and also to further increase the clarity of the molten glass.

Here, the molten glass having higher clarity means that the number of bubbles per 1 g of glass bulk, as measured by the aforementioned evaluation method of clarity, is less than 150. In addition, the compositional feature of the molten glass being more uniform means that the compositional uniformity is 8.0% or less, as calculated by the aforementioned evaluation method of compositional uniformity.

In addition, when the glass composition for glass fiber of the present invention includes $SiO_2$, $Al_2O_3$, $MgO$, $CaO$, $ZnO$, $TiO_2$, $P_2O_5$, and MxOy in the respective ranges described above with respect to the total amount, and the content Z of $ZnO$, the content P of $P_2O_5$, and the content M of MxOy satisfy the formula (2), the glass composition for glass fiber further includes $Fe_2O_3$ in the range of 0.01 to 2.00% by mass and $SnO_2$ in the range of 0.01 to 2.00% by mass, and the content F of $Fe_2O_3$ and the content S of $SnO_2$ preferably satisfy the following formula (3):

$$0.06 \leq S/F \leq 40.75 \ ... \ (3).$$

When the glass composition for glass fiber of the present invention includes $SiO_2$, $Al_2O_3$, $MgO$, $CaO$, $ZnO$, $TiO_2$, $P_2O_5$, and MxOy in the respective ranges described above with respect to the total amount, and the content Z of $ZnO$, the content P of $P_2O_5$, and the content M of MxOy satisfy the formula (2), by the glass composition for glass fiber further including $Fe_2O_3$ in the range of 0.01 to 2.00% by mass and $SnO_2$ in the range of 0.01 to 2.00% by mass, and the content F of $Fe_2O_3$ and the content S of $SnO_2$ satisfying the formula (3), it is possible to obtain glass fiber with a high elastic modulus and a low coefficient of linear thermal expansion, to further increase the clarity of the molten glass, and to make the compositional feature of the molten glass further uniform.

Here, the compositional feature of the molten glass being further uniform means that the compositional uniformity is 5.0% or less, as calculated by the aforementioned evaluation method of compositional uniformity.

In addition, the glass composition for glass fiber of the present invention includes $SiO_2$, $Al_2O_3$, MgO, CaO, ZnO, $TiO_2$, $P_2O_5$, and MxOy in the respective ranges described above with respect to the total amount, and the content Z of ZnO, the content P of $P_2O_5$, and the content M of MxOy preferably satisfy the following formula (4):

$$0.183 \leq (Z/P) \times M^{1/2} \leq 0.582 \dots (4).$$

By the glass composition for glass fiber of the present invention including $SiO_2$, $Al_2O_3$, MgO, CaO, ZnO, $TiO_2$, $P_2O_5$, and MxOy in the respective ranges described above with respect to the total amount, and the content Z of ZnO, the content P of $P_2O_5$, and the content M of MxOy satisfying the formula (4), it is possible to obtain glass fiber with a high elastic modulus and a low coefficient of linear thermal expansion, to further increase the clarity of the molten glass, and also to make the compositional feature of the molten glass even further uniform.

Here, the compositional feature of the molten glass being even further uniform means that the compositional uniformity is 3.0% or less, as calculated by the aforementioned evaluation method of compositional uniformity.

The glass fiber of the present invention includes a glass filament formed from any of the aforementioned glass compositions for glass fiber. Also, the glass fiber woven fabric or glass fiber-reinforced resin composition of the present invention includes the glass fiber of the present invention.

Description of Embodiments

Hereinafter, embodiments of the present invention will be described in detail.

The glass composition for glass fiber of the first aspect of the present embodiment includes $SiO_2$ in the range of 42.00 to 70.00% by mass, $Al_2O_3$ in the range of 10.00 to 30.00% by mass, MgO in the range of 0.00 to 8.00% by mass, CaO in the range of 0.00 to 5.00% by mass, ZnO in the range of 2.00 to 25.00% by mass, $TiO_2$ in the range of 0.00 to 5.00% by mass, $P_2O_5$ in the range of 2.00 to 17.30% by mass, and MxOy (at least one or more oxides selected from the group consisting of $Fe_2O_3$, $SnO_2$, $CeO_2$, $MnO_2$, $Sb_2O_3$, and $As_2O_3$) in the range of 0.01 to 2.00% by mass in total, with respect to the total amount, and the content Z of ZnO, the content P of $P_2O_5$, and the content M of MxOy satisfy the following formula (1), and preferably satisfy the following formula (2):

$$0.088 \leq (Z/P) \times M^{1/2} \leq 3.554 \dots (1)$$

$$0.183 \leq (Z/P) \times M^{1/2} \leq 1.775 \dots (2).$$

According to the glass composition for glass fiber of the first aspect of the present embodiment, by including $SiO_2$, $Al_2O_3$, MgO, CaO, ZnO, $TiO_2$, $P_2O_5$, and MxOy in the respective ranges described above with respect to the total amount, it is possible to obtain glass fiber with a high elastic modulus and a low coefficient of linear thermal expansion.

Also, by the glass composition for glass fiber of the first aspect of the present embodiment including $SiO_2$, $Al_2O_3$, MgO, CaO, ZnO, $TiO_2$, $P_2O_5$, and MxOy in the respective ranges described above with respect to the total amount, and the content Z of ZnO, the content P of $P_2O_5$, and the content M of MxOy satisfying the formula (1), when MxOy generates gas in the molten glass, the generated gas entraps minute bubbles existing in the molten glass to form large bubbles, and these large bubbles easily rise to the top of the molten glass and escape. As a result, the clarity of the molten glass can be increased and bubbles (hollows) included in glass fiber obtained from the glass composition for glass fiber can be reduced. In addition, when the large bubbles rise to the top of the molten glass, the molten glass is stirred, which can facilitate dissolution of ZnO and $P_2O_5$, making the compositional feature of the molten glass uniform.

Note that, in the molten glass, $Fe_2O_3$ generates gas mainly at a temperature in the range of 1400 to 1500°C, $SnO_2$ generates gas mainly at a temperature in the range of 1500 to 1630°C, $CeO_2$ generates gas mainly at a temperature in the range of 1100 to 1400°C, $MnO_2$ generates gas mainly at a temperature in the range of 1100 to 1400°C, $Sb_2O_3$ generates gas mainly at a temperature in the range of 1000 to 1300°C, and $As_2O_3$ generates gas mainly at a temperature in the range of 1300 to 1600°C.

Furthermore, according to the glass composition for glass fiber of the first aspect of the present embodiment, by the content Z of ZnO, the content P of $P_2O_5$, and the content M of MxOy satisfying the formula (2), it is possible to obtain glass fiber with a high elastic modulus and a low coefficient of linear thermal expansion, to make the compositional feature of the molten glass more uniform, and also to further increase the clarity of the molten glass.

In addition, when the glass composition for glass fiber of the second aspect of the present embodiment includes $SiO_2$, $Al_2O_3$, MgO, CaO, ZnO, $TiO_2$, $P_2O_5$, and MxOy in the respective ranges described above with respect to the total amount, and the content Z of ZnO, the content P of $P_2O_5$, and the content M of MxOy satisfy the formula (2), the glass composition for glass fiber includes $Fe_2O_3$ in the range of 0.01 to 2.00% by mass and $SnO_2$ in the range of 0.01 to 2.00% by mass, and the content F of $Fe_2O_3$ and the content S of $SnO_2$ satisfy the following formula (3):

$$0.06 \leq S/F \leq 40.75 \, ... \, (3).$$

When the glass composition for glass fiber of the second aspect of the present embodiment includes $SiO_2$, $Al_2O_3$, MgO, CaO, ZnO, $TiO_2$, and MxOy in the respective ranges described above with respect to the total amount, and the content Z of ZnO, the content P of $P_2O_5$, and the content M of MxOy satisfy the formula (2), by the glass composition for glass fiber further including $Fe_2O_3$ in the range of 0.01 to 2.00% by mass and $SnO_2$ in the range of 0.01 to 2.00% by mass, and the content F of $Fe_2O_3$ and the content S of $SnO_2$ satisfying the formula (3), it is possible to obtain glass fiber with a high elastic modulus and a low coefficient of linear thermal expansion, to further increase the clarity of the molten glass, and to make the compositional feature of the molten glass further uniform.

Furthermore, the glass composition for glass fiber of the third aspect of the present embodiment includes $SiO_2$, $Al_2O_3$, MgO, CaO, ZnO, $TiO_2$, $P_2O_5$, and MxOy in the respective ranges described above with respect to the total amount, and the content Z of ZnO, the content P of $P_2O_5$, and the content M of MxOy satisfy the following formula (4):

$$0.183 \leq (Z/P) \times M^{1/2} \leq 0.582 \, ... \, (4).$$

By the glass composition for glass fiber of the third aspect of the present embodiment including $SiO_2$, $Al_2O_3$, MgO, CaO, ZnO, $TiO_2$, $P_2O_5$, and MxOy in the respective ranges described above with respect to the total amount, and the content Z of ZnO, the content P of $P_2O_5$, and the content M of MxOy satisfying the formula (4), it is possible to obtain glass fiber with a high elastic modulus and a low coefficient of linear thermal expansion, to further increase the clarity of the molten glass, and also to make the compositional feature of the molten glass even further uniform.

Note that, in the glass composition for glass fiber of each aspect of the present embodiment, a larger value of Z/P tends to increase the coefficient of linear thermal expansion of the resulting glass fiber, whereas a smaller value of Z/P tends to decrease the elastic modulus of the resulting glass fiber. Meanwhile, a larger value of M tends to cause an excessive amount of gas to be generated in the molten glass, resulting in deterioration of the clarity of the molten glass, whereas a smaller value of M tends to cause failure in generating a sufficient amount of gas in the molten glass for stirring the molten glass, resulting in deterioration of the uniformity of the molten glass and deterioration of the clarity.

Therefore, the value of $(Z/P) \times M^{1/2}$ is considered to indicate the balance between the coefficient of linear thermal expansion and elastic modulus of the resulting glass fiber and the clarity and compositional uniformity of the molten glass.

Also, in the glass composition for glass fiber of the second aspect of the present embodiment, a larger value of S/F tends to cause the effect of stirring the molten glass in the temperature range of 1400 to 1500°C to become inadequate, thus deteriorating the compositional uniformity of the molten glass, whereas a smaller value of S/F tends to cause the effect of stirring the molten glass in the temperature range of 1500 to 1630°C and the effect of entrapping minute bubbles to become inadequate, thus deteriorating the compositional uniformity and clarity of the molten glass. Therefore, the value of S/F is considered to indicate the balance between the effect of stirring the molten glass in the temperature range of 1400 to 1500°C and the effect of stirring the molten glass in the temperature range of 1500 to 1630°C.

The value of S/F is preferably in the range of 0.20 to 14.00, and preferably in the range of 0.30 to 1.40.

In the glass composition for glass fiber of each of the above aspects of the present embodiment, when the content of $SiO_2$ is less than 42.00% by mass with respect to the total amount of the glass composition for glass fiber, the working temperature range is narrowed and crystals may be crystallized during spinning, resulting in nozzle blockage. Also, when the content of $SiO_2$ is more than 70.00% by mass, the 1000 poise temperature is higher and the meltability is deteriorated, and unmelted $SiO_2$ flows into the nozzle as foreign matter and causes cuts during spinning, which deteriorates productivity.

In the glass composition for glass fiber of each of the above aspects of the present embodiment, the content of $SiO_2$ with respect to the total amount of the glass composition for glass fiber is preferably in the range of 44.00 to 65.00% by mass, more preferably in the range of 45.00 to 62.60% by mass, still more preferably in the range of 46.30 to 58.50% by mass, particularly preferably in the range of 47.90 to 55.90% by mass, and especially preferably in the range of 48.90 to 54.90% by mass.

In the glass composition for glass fiber of each of the above aspects of the present embodiment, when the content of $Al_2O_3$ is less than 10.00% by mass with respect to the total amount of the glass composition for glass fiber, the 1000 poise temperature is higher, the meltability is deteriorated, and the elastic modulus decreases. Also, when the content of $Al_2O_3$ is more than 30.00% by mass, crystals are more likely to precipitate, which narrows the working temperature range and deteriorates the spinnability.

In the glass composition for glass fiber of each of the above aspects of the present embodiment, the content of $Al_2O_3$ with respect to the total amount of the glass composition for glass fiber is preferably in the range of 19.50 to 28.40% by mass, more preferably in the range of 20.50 to 27.80% by mass, still more preferably in the range of 22.10 to 27.20% by mass, particularly preferably in the range of 22.60 to 26.40% by mass, and especially preferably in the range of 23.20 to 25.80% by mass.

In the glass composition for glass fiber of each of the above aspects of the present embodiment, when the content of MgO is more than 8.00% by mass with respect to the total amount of the glass composition for glass fiber, glass fiber with a low coefficient of linear thermal expansion cannot be obtained.

In the glass composition for glass fiber of each of the above aspects of the present embodiment, the content of MgO with respect to the total amount of the glass composition for glass fiber is preferably in the range of 0.00 to 5.90% by mass, more preferably in the range of 0.50 to 5.40% by mass, still more preferably in the range of 1.10 to 4.90% by mass, particularly preferably in the range of 1.50 to 4.40% by mass, especially preferably in the range of 1.90 to 2.70% by mass, and markedly preferably in the range of 2.60 to 3.60% by mass.

In the glass composition for glass fiber of each of the above aspects of the present embodiment, when the content of CaO is more than 5.00% by mass with respect to the total amount of the glass composition for glass fiber, the liquid phase temperature is higher and the spinnability is deteriorated.

In the glass composition for glass fiber of each of the above aspects of the present embodiment, the content of CaO with respect to the total amount of the glass composition for glass fiber is preferably in the range of 0.00 to 5.00% by mass, more preferably in the range of 0.00 to 2.50% by mass, still more preferably in the range of 0.00 to 0.90% by mass, particularly preferably in the range of 0.00 to 0.40% by mass, especially preferably in the range of 0.00% by mass or more and less than 0.10% by mass, and markedly preferably in the range of 0.00% by mass or more and less than 0.05% by mass.

In the glass composition for glass fiber of each of the above aspects of the present embodiment, when the content of ZnO is 2.00% by mass or less with respect to the total amount of the glass composition for glass fiber, the 1000 poise temperature is higher and the meltability is deteriorated. Also, when the content of ZnO is more than 25.00% by mass, glass fiber with a low coefficient of linear thermal expansion cannot be obtained.

In the glass composition for glass fiber of each of the above aspects of the present embodiment, the content of ZnO with respect to the total amount of the glass composition for glass fiber is preferably in the range of 2.50 to 22.00% by mass, more preferably in the range of 3.0 to 18.00% by mass, still more preferably in the range of 4.10 to 14.10% by mass, particularly preferably in the range of 5.20 to 11.00% by mass, especially preferably in the range of 6.00 to 10.10% by mass, and markedly preferably in the range of 6.50 to 9.50% by mass.

In the glass composition for glass fiber of each of the above aspects of the present embodiment, when the content of $TiO_2$ is more than 5.00% by mass with respect to the total amount of the glass composition for glass fiber, it is not possible to lower the melt viscosity while maintaining a low coefficient of linear thermal expansion. In addition, the liquid phase temperature becomes too high and the working temperature range is narrowed.

In the glass composition for glass fiber of each of the above aspects of the present embodiment, the content of $TiO_2$ with respect to the total amount of the glass composition for glass fiber is preferably in the range of 0.00 to 2.50% by mass, more preferably in the range of 0.00 to 1.80% by mass, still more preferably in the range of 0.00 to 1.20% by mass, and particularly preferably in the range of 0.00 to 0.90% by mass.

In the glass composition for glass fiber of each of the above aspects of the present embodiment, when the content of $P_2O_5$ is less than 2.00% by mass with respect to the total amount of the glass composition for glass fiber, the working temperature range is narrowed and crystals may be crystallized during spinning, resulting in nozzle blockage. Also, when the content of $P_2O_5$ is more than 17.30% by mass, the 1000 poise temperature is higher, the meltability is deteriorated, and the liquid phase temperature is higher, making it difficult to perform spinning.

In the glass composition for glass fiber of each of the above aspects of the present embodiment, the content of $P_2O_5$ with respect to the total amount of the glass composition for glass fiber is preferably in the range of 3.80 to 17.00% by mass, more preferably in the range of 5.50 to 15.50% by mass, still more preferably in the range of 6.50 to 14.90% by mass, particularly preferably in the range of 8.30 to 13.50% by mass, especially preferably in the range of 10.10 to 13.60% by mass, and markedly preferably in the range of 11.00 to 13.30% by mass.

The glass composition for glass fiber of each mode of the present embodiment includes MxOy in the range of 0.01 to 2.00% by mass with respect to the total amount of the glass composition for glass fiber.

MxOy is one or more oxides selected from the group consisting of $Fe_2O_3$, $SnO_2$, $CeO_2$, $MnO_2$, $Sb_2O_3$, and $As_2O_3$. In order to avoid contaminating the facility due to volatilization during melting, which would make long term operation impossible, MxOy is preferably one or more oxides selected from the group consisting of $Fe_2O_3$, $SnO_2$, $CeO_2$, and $MnO_2$, which are oxides of metallic elements, more preferably one or more oxides selected from the group consisting of $Fe_2O_3$, $SnO_2$, and $MnO_2$, which are not oxides of rare earth elements, from the viewpoint of production cost, and still more preferably one or more oxides selected from the group consisting of $Fe_2O_3$ and $SnO_2$ from the viewpoint of low toxicity of the raw material.

In the glass composition for glass fiber of each mode of the present embodiment, from the viewpoint of widening the temperature range at which gas is generated, thereby increasing the effect of stirring the molten glass over a long period of time until the molten glass temperature rises from a low temperature to a high temperature, the glass composition for glass fiber of each mode of the present embodiment preferably includes any two or more oxides selected from the above group, and more preferably includes $Fe_2O_3$ and $SnO_2$.

Note that, in the case where the glass composition for glass fiber includes any two or more oxides selected from the above group as MxOy, the content M of MxOy represents the total content of all oxides included in MxOy.

In the glass composition for glass fiber of each of the above aspects of the present embodiment, when the content of MxOy is less than 0.01% by mass with respect to the total amount of the glass composition for glass fiber, it is not possible to generate a sufficient amount of gas in the molten glass for stirring the molten glass. Also, when the content of MxOy is more than 2.00% by mass, the amount of gas generated in the molten glass is excessive, and the clarity of the molten glass is deteriorated.

In the glass composition for glass fiber of each of the above aspects of the present embodiment, the content of MxOy with respect to the total amount of the glass composition for glass fiber is preferably in the range of 0.10 to 1.40% by mass, more preferably in the range of 0.15 to 1.20% by mass, still more preferably in the range of 0.30 to 0.90% by mass, and particularly preferably in the range of 0.40 to 0.60% by mass.

In the case where the glass composition for glass fiber of each of the above modes of the present embodiment includes $Fe_2O_3$, $SnO_2$, $CeO_2$, $MnO_2$, $Sb_2O_3$, and $As_2O_3$, their contents are each independently in the range of 0.01 to 2.00% by mass, preferably in the range of 0.01 to 1.50% by mass, more preferably in the range of 0.10 to 0.90% by mass, still more preferably in the range of 0.30 to 0.70% by mass, and particularly preferably in the range of 0.40 to 0.44% by mass with respect to the total amount of the glass composition for glass fiber.

In the case where the glass composition for glass fiber of each of the above modes of the present embodiment includes $Fe_2O_3$ and $SnO_2$, the ratio of the content S of $SnO_2$ to the content F of $Fe_2O_3$ (S/F) is preferably in the range of 0.06 to 40.75, more preferably in the range of 0.20 to 14.00, still more preferably in the range of 0.25 to 4.90, and particularly preferably in the range of 0.30 to 1.40.

In addition, from the viewpoint of reducing the melt viscosity of molten glass and facilitating the formation of longer fibers, the glass composition for glass fiber of the present embodiment may also include $ZrO_2$. In the case where $ZrO_2$ is included, the content of $ZrO_2$ with respect to the total amount of the glass composition for glass fiber is, for example, in the range of 3.00% by mass or less, preferably in the range of 1.00% by mass or less, more preferably in the range of 0.60% by mass or less, still more preferably in the range of 0.40% by mass or less, particularly preferably in the range of 0.20% by mass or less, especially preferably in the range of 0.10% by mass or less, and markedly preferably in the range of 0.001% by mass or less.

The glass composition for glass fiber of the present embodiment may also include $B_2O_3$ from the viewpoint of improving spinnability and obtaining glass fiber with a low coefficient of linear thermal expansion. In the case where $B_2O_3$ is included, the content of $B_2O_3$ with respect to the total amount of the glass composition for glass fiber is, for example, in the range of 10.00% by mass or less, preferably in the range of 7.90% by mass or less, more preferably in the range of 0.50 to 5.90% by mass, still more preferably in the range of 1.00 to 4.80% by mass, and particularly preferably in the range of 1.50 to 3.50% by mass.

The glass composition for glass fiber of the present embodiment may also include $F_2$ and $Cl_2$. In the case where $F_2$ and $Cl_2$ are included, the total content of $F_2$ and $Cl_2$ with respect to the total amount of the glass composition for glass fiber is, for example, in the range of 3.00% by mass or less, preferably in the range of 1.00% by mass or less, more preferably in the range of 0.40% by mass or less, still more preferably in the range of 0.20% by mass or less, particularly preferably in the range of 0.10% by mass or less, and especially preferably in the range of 0.001% by mass or less.

The glass composition for glass fiber of the present embodiment may also include $Li_2O$, $Na_2O$, and $K_2O$. In the case where $Li_2O$, $Na_2O$, and $K_2O$ are included, from the viewpoint that inclusion in a large amount may deteriorate the water resistance of the glass fiber and worsen the coefficient of linear thermal expansion, the total content of $Li_2O$, $Na_2O$, and $K_2O$ with respect to the total amount of the glass composition for glass fiber is, for example, in the range of 1.00% by mass or less, preferably in the range of 0.50% by mass or less, more preferably in the range of less than 0.10% by mass, still more preferably in the range of 0.05% by mass or less, particularly preferably in the range of 0.02% by mass or less, especially preferably in the range of 0.03% by mass or less, and most preferably in the range of 0.01% by mass or less.

Also, in the glass composition for glass fiber of the present embodiment, the ratio of the content of $P_2O_5$ to the content of ZnO ($P_2O_5$/ZnO) is preferably in the range of 0.40 to 5.60. When the ratio of the content of $P_2O_5$ to the content of ZnO ($P_2O_5$/ZnO) is less than 0.40, there is a tendency that the working temperature range is smaller or the coefficient of linear thermal expansion of glass fiber formed from the glass composition for glass fiber is larger, and when the ratio is more than 5.60, there is a tendency that the 1000 poise temperature is too high. The ratio of the content of $P_2O_5$ to the content of ZnO ($P_2O_5$/ZnO) is more preferably in the range of 0.70 to 4.50, still more preferably in the range of 0.80 to 3.70, particularly preferably in the range of 0.90 to 2.80, and especially preferably in the range of 0.95 to 2.00.

In the glass composition for glass fiber of the present embodiment, the total content of $SiO_2$, $Al_2O_3$, MgO, CaO,

ZnO, $TiO_2$, $P_2O_5$, and MxOy with respect to the total amount is, for example, 91.0% by mass or more, preferably 95.0% by mass or more, more preferably 98.0% by mass or more, still more preferably 99.0% by mass or more, markedly preferably 99.3% by mass or more, particularly preferably 99.5% by mass or more, especially preferably 99.7% by mass or more, and most preferably 99.9% by mass or more.

Furthermore, the glass composition for glass fiber of the present embodiment may include, as impurities attributable to raw materials, oxides of Sr, Ba, Co, Ni, Cu, Cr, Mo, W, Y, La, Bi, Gd, Pr, Sc, Pb, Cd, or Yb in the range of less than 3.00% by mass, preferably in the range of less than 2.00% by mass, and more preferably in the range of less than 1.00% by mass, in total with respect to the total amount of the glass composition for glass fiber.

In particular, in the case where the glass composition for glass fiber of the present embodiment includes SrO, BaO, $Y_2O_3$, $La_2O_3$, $Bi_2O_3$, $Gd_2O_3$, $Pr_2O_3$, $Sc_2O_3$, or $Yb_2O_3$ as impurities, the content thereof with respect to the total amount of the glass composition for glass fiber is each independently preferably in the range of less than 0.40% by mass, more preferably in the range of less than 0.20% by mass, still more preferably in the range of less than 0.10% by mass, particularly preferably in the range of less than 0.05% by mass, especially preferably in the range of less than 0.01% by mass, and most preferably in the range of less than 0.001% by mass.

Regarding the content of each component in the glass composition for glass fiber, the content of Li as the light element can be measured using an ICP emission spectroscopic analyzer. The contents of the other elements can be measured using a wavelength dispersive X-ray fluorescence analyzer.

Examples of the measurement method can include the following method. First, a glass batch is placed in a platinum crucible and in an electric furnace, melted with stirring while being held at a temperature of 1650°C for 6 hours to obtain a homogeneous molten glass. Alternatively, glass fiber is placed in a platinum crucible and melted with stirring while being held at a temperature of 1650°C for 6 hours in an electric furnace to obtain a homogeneous molten glass.

The glass batch is prepared by mixing a glass raw material. When organic matter adheres to the surface of the glass fiber, or when glass fiber is mainly included as a reinforcing material in organic matter (resin), the glass fiber is used after the organic matter is removed by, for example, heating for about 0.5 to 24 hours in a muffle furnace at 300 to 650°C.

Next, the obtained molten glass is poured onto a carbon plate to produce a glass cullet, and then the glass cullet is pulverized and powdered to obtain glass powder.

Next, regarding Li as a light element, the glass powder is thermally decomposed with an acid and then quantitatively analyzed using an ICP emission spectroscopic analyzer. Regarding other elements, the glass powder is molded into a disc shape by a pressing machine and then quantitatively analyzed using a wavelength dispersive X-ray fluorescence analyzer. For the quantitative analysis using a wavelength dispersive X-ray fluorescence analyzer, specifically, specimens for calibration curve are prepared based on the measurement results from the fundamental parameter method, and the analysis can be performed by the calibration curve method. The content of each component in the specimens for calibration curve can be quantitatively analyzed by an ICP emission spectroscopic analyzer. These quantitative analysis results are converted in terms of oxides to calculate the content of each component and the total amount, and the above content (% by mass) of each component can be determined from these numerical values.

The glass fiber of the present embodiment can be formed from the glass composition for glass fiber of each of the above aspects of the present embodiment, for example, as follows. First, a glass raw material is prepared to be the composition of the glass composition for glass fiber of each of the above aspects of the present embodiment, based on the components contained in the ore to be the glass raw material, the content of each component, and the amount of each component volatilized during the melting process. Next, the prepared glass raw material (glass batch) is supplied to a melting furnace, and is melted at a temperature range of 1000 poise temperature or higher, specifically a temperature in the range of 1450 to 1650°C. Then, the glass batch (molten glass) melted at the temperature range described above is discharged from 100 to 8000 nozzle tips or holes of the bushing controlled at a predetermined temperature, and cooled while stretched by winding at high speed to form glass single fiber (glass filament) by solidification.

When forming the glass fiber of the present embodiment, glass filament discharged from one nozzle tip or hole, cooled and solidified typically has a perfect circle cross-sectional shape and has a diameter in the range of 2.0 to 35.0 μm. In applications that require a low coefficient of linear thermal expansion, the glass filament preferably has a diameter in the range of 3.0 to 6.0 μm and more preferably a diameter in the range of 3.0 to 4.5 μm. On the other hand, when the above nozzle tip has a non-circular shape and has a protrusion or a notch for rapidly cooling the molten glass, controlling the temperature condition can provide a glass filament having a non-circular (for example, elliptical and long-oval) cross-sectional shape. When the glass filament has an elliptical or long-oval cross-sectional shape, the ratio of the major axis to the minor axis of the cross-sectional shape (major axis/minor axis) is, for example, in the range of 2.0 to 10.0 and the fiber diameter (converted fiber diameter) when the cross-sectional area is converted to a perfect circle is, for example, in the range of 2.0 to 35.0 μm.

The glass fiber of the present embodiment typically has a shape of a glass fiber bundle (glass strand) in which the above glass filaments in the range of 10 to 8000 filaments are bundled, and has a weight in the range of 0.3 to 10000.0 tex (g/km).

The glass fiber of the present embodiment can have various forms, which are obtained by further processing the above glass strands, such as yarns, woven fabrics, knitted fabrics, non-woven fabrics (including chopped strand mats and multiaxial non-woven fabrics), chopped strands, rovings, and powders.

According to the glass composition for glass fiber of each of the above aspects of the present embodiment, the elastic modulus of the resulting glass fiber is in the range of 70.0 GPa or more, preferably in the range of 75.0 GPa or more, more preferably in the range of 78.0 GPa or more, and still more preferably in the range of 79.0 GPa or more, and the upper limit is not particularly restricted, but is particularly preferably in the range of 80.0 to 90.0 GPa, and especially preferably in the range of 81.0 to 86.0 GPa.

Also, according to the glass composition for glass fiber of each of the above aspects of the present embodiment, the coefficient of linear thermal expansion of the resulting glass fiber is in the range of 3.0 ppm/K or less, preferably in the range of 2.9 ppm/K or less, and more preferably in the range of less than 2.5 ppm/K, and the lower limit is not particularly restricted, but is still more preferably in the range of 1.5 to 2.3 ppm/K, and particularly preferably in the range of 1.8 to 2.2 ppm/K.

Also, according to the glass composition for glass fiber of each of the above modes of the present embodiment, the dielectric constant of the resulting glass fiber at a measurement frequency of 10 GHz is preferably in the range of 4.4 to 5.4, and the dielectric loss tangent of the resulting glass fiber at a measurement frequency of 10 GHz is preferably in the range of 0.0030 to 0.0060.

The glass fiber of the present embodiment may be coated with an organic matter on the surface thereof for the purposes such as improvement of glass filament convergence, improvement of adhesiveness between glass fiber and a resin, and improvement of uniform dispersibility of glass fiber in a mixture of glass fiber and resin or inorganic material. Examples of such an organic matter can include starch, urethane resins, epoxy resins, vinyl acetate resins, acrylic resins, modified polypropylene (particularly carboxylic acid-modified polypropylene), and a copolymer of (poly)carboxylic acid (particularly maleic acid) and an unsaturated monomer.

The glass fiber of the present embodiment may be coated with the resin composition including a silane coupling agent, a lubricant, surfactant, and the like in addition to these resins. The glass fiber of the present embodiment may be coated with the treating agent composition not including the above resins and including a silane coupling agent, surfactant, and the like.

Such a resin composition or treating agent composition covers the glass fiber at a rate in the range of 0.1 to 2.0% by mass based on the mass of the glass fiber of the present embodiment in a state where it is not coated with the resin composition or the treating agent composition.

The glass fiber can be coated with the organic matter by applying a resin solution or a resin composition solution to the glass fiber using a known method such as a roller applicator, for example, in the manufacturing process of the glass fiber and then drying the glass fiber to which the resin solution or the resin composition solution is applied. The glass fiber of the present embodiment in the form of a woven fabric can be coated with the organic matter by immersing the glass fiber in the treating agent composition solution and then drying the glass fiber to which the treating agent composition has been applied.

Examples of the silane coupling agent include aminosilanes, chlorosilanes, epoxysilanes, mercaptosilanes, vinylsilanes, acrylsilanes, and cationic silanes. As for the silane coupling agent, these compounds can be used alone, or two or more of them can be used in combination.

Examples of the aminosilane include γ-aminopropyltriethoxysilane, N-β-(aminoethyl)-γ-aminopropyltrimethoxysilane, N-β-(aminoethyl)-N'-β-(aminoethyl)-γ-aminopropyltrimethoxysilane, and γ-anilinopropyltrimethoxysilane.

Examples of the chlorosilane include γ-chloropropyltrimethoxysilane.

Examples of the epoxysilane include γ-glycidoxypropyltrimethoxysilane and β-(3,4-epoxycyclohexyl)ethyltrimethoxysilane.

Examples of the mercaptosilane can include γ-mercaptotrimethoxysilane.

Examples of the vinylsilane include vinyl trimethoxysilane and N-β-(N-vinylbenzylaminoethyl)-γ-aminopropyltrimethoxysilane.

Examples of the acrylsilane include γ-methacryloxypropyltrimethoxysilane.

Examples of the cationic silane can include N-(vinylbenzyl)-2-aminoethyl-3-aminopropyltrimethoxysilane hydrochloride and N-phenyl-3-aminopropyltrimethoxysilane hydrochloride.

Examples of the lubricant include modified silicone oils, animal oils and hydrogenated products thereof, vegetable oils and hydrogenated products thereof, animal waxes, vegetable waxes, mineral waxes, condensates of a higher saturated fatty acid and a higher saturated alcohol, polyethyleneimine, polyalkylpolyamine alkylamide derivatives, fatty acid amides, and quaternary ammonium salts. As for the lubricant, these can be used alone, or two or more of them can be used in combination.

Examples of the animal oil include beef tallow.

Examples of the vegetable oil include soybean oil, coconut oil, rapeseed oil, palm oil, and castor oil.

Examples of the animal wax include beeswax and lanolin.

Examples of the vegetable wax include candelilla wax and carnauba wax.

Examples of the mineral wax include paraffin wax and montan wax.

Examples of the condensate of a higher saturated fatty acid and a higher saturated alcohol include stearates such as lauryl stearate.

Examples of the fatty acid amide include dehydrated condensates of a polyethylenepolyamine such as diethylenetriamine, triethylenetetramine, or tetraethylenepentamine and a fatty acid such as lauric acid, myristic acid, palmitic acid, or stearic acid.

Examples of the quaternary ammonium salt include alkyltrimethylammonium salts such as lauryltrimethylammonium chloride.

Examples of the surfactant can include nonionic surfactants, cationic surfactants, anionic surfactants, and amphoteric surfactants. As for the surfactant, these can be used alone, or two or more of them can be used in combination.

Examples of the nonionic surfactant can include ethylene oxide propylene oxide alkyl ether, polyoxyethylene alkyl ether, polyoxyethylene-polyoxypropylene-block copolymer, alkyl polyoxyethylene-polyoxypropylene block copolymer ether, polyoxyethylene fatty acid ester, polyoxyethylene fatty acid monoester, polyoxyethylene fatty acid diester, polyoxyethylene sorbitan fatty acid ester, glycerol fatty acid ester ethylene oxide adduct, polyoxyethylene castor oil ether, hydrogenated castor oil ethylene oxide adduct, alkylamine ethylene oxide adduct, fatty acid amide ethylene oxide adduct, glycerol fatty acid ester, polyglycerol fatty acid ester, pentaerythritol fatty acid ester, sorbitol fatty acid ester, sorbitan fatty acid ester, sucrose fatty acid ester, polyhydric alcohol alkyl ether, fatty acid alkanolamide, acetylene glycol, acetylene alcohol, ethylene oxide adduct of acetylene glycol, and ethylene oxide adduct of acetylene alcohol.

Examples of the cationic surfactant can include alkyldimethylbenzylammonium chloride, alkyltrimethylammonium chloride, alkyl dimethyl ethyl ammonium ethyl sulfate, higher alkylamine acetate, higher alkylamine hydrochloride, adduct of ethylene oxide to a higher alkylamine, condensate of a higher fatty acid and polyalkylene polyamine, a salt of an ester of a higher fatty acid and alkanolamine, a salt of higher fatty acid amide, imidazoline cationic surfactant, and alkyl pyridinium salt.

Examples of the anionic surfactant can include higher alcohol sulfate salts, higher alkyl ether sulfate salts, $\alpha$-olefin sulfate salts, alkylbenzene sulfonate salts, $\alpha$-olefin sulfonate salts, reaction products of fatty acid halide and N-methyl taurine, dialkyl sulfosuccinate salts, higher alcohol phosphate ester salts, and phosphate ester salts of higher alcohol ethylene oxide adduct. Examples of the amphoteric surfactant can include amino acid amphoteric surfactants such as alkali metal salts of alkylaminopropionic acid, betaine amphoteric surfactants such as alkyldimethylbetaine, and imidazoline amphoteric surfactants.

The glass fiber woven fabric of the present embodiment includes the above glass fiber of the present embodiment. Specifically, the glass fiber woven fabric of the present embodiment can be obtained by weaving the above glass fiber of the present embodiment as at least a part of warp yarns or weft yarns with a loom known per se. Examples of the loom may include jet looms such as air jet or water jet looms, shuttle looms, and rapier looms. Examples of weaving with the loom may include plain weaving, satin weaving, mat weaving, and twill weaving. From the viewpoint of production efficiency, plain weaving is preferred.

In the glass fiber woven fabric of the present embodiment, the above glass fiber of the present embodiment is preferably formed by bundling glass filaments in the range of 35 to 20000 filaments, each having a diameter in the range of 3.0 to 21.0 $\mu$m, has a number of twists in the range of 0 to 1.0 twist/25 mm, and has a mass in the range of 0.9 to 600.0 tex (g/km).

In the glass fiber woven fabric of the present embodiment, in the case where the above glass fiber of the present embodiment is employed as warp yarns or weft yarns, the warp yarn weaving density is preferably in the range of 10 to 120 yarns/25 mm, and the weft yarn weaving density is preferably in the range of 10 to 120 yarns/25 mm.

The glass fiber woven fabric of the present embodiment, after woven, may be subjected to desizing treatment, surface treatment, and opening treatment.

An example of the desizing treatment can be a treatment including placing the glass fiber woven fabric in a heating oven in which the atmosphere temperature is a temperature in the range of 350°C to 400°C for a time period in the range of 40 to 80 hours to thereby pyrolytically decompose organic matter adhering to the glass fiber.

An example of the surface treatment can be a treatment including immersing the glass fiber woven fabric in a solution including the silane coupling agent or including the silane coupling agent and the surfactant, squeezing extra water therefrom, and heat-drying the woven fabric at a temperature in the range of 80 to 180°C for a time period in the range of 1 to 30 minutes.

An example of the opening treatment is a treatment in which the warp yarns of the glass fiber woven fabric are subjected to opening by means of water flow pressure, opening by means of high-frequency vibration using a liquid as a medium, opening by means of the pressure of a fluid having a surface pressure, opening by means of pressing with a roll, or the like under a tension in the range of 30 to 200 N to thereby widen the width of the warp yarns and weft yarns.

The glass fiber woven fabric of the present embodiment has a mass per unit area in the range of 7.0 to 750.0 g/m$^2$ and preferably has a thickness in the range of 8.0 to 500.0 $\mu$m.

The yarn width of the warp yarns of the glass fiber woven fabric of the present embodiment is preferably in the range of 110 to 600 μm and the yarn width of the weft yarns thereof is preferably in the range of 110 to 600 μm.

The glass fiber woven fabric of the present embodiment may comprise a surface treatment layer including the silane coupling agent or the silane coupling agent and the surfactant. When the glass fiber woven fabric of the present embodiment includes the surface treatment layer, the surface treatment layer can have a mass in the range of 0.03 to 1.50% by mass, for example, with respect to the total amount of the glass fiber woven fabric including the surface treatment layer.

The glass fiber-reinforced resin composition of the present embodiment includes the above glass fiber of the present embodiment. Specifically, the glass fiber-reinforced resin composition of the present embodiment includes, for example, 10 to 90% by mass of glass fiber with respect to the total amount of the glass fiber-reinforced resin composition, as the glass fiber-reinforced resin composition including resin (thermoplastic resin or thermosetting resin), glass fiber, and other additives. Also, the glass fiber-reinforced resin composition of the present embodiment includes, for example, 90 to 10% by mass of a resin, and includes other additives in the range of 0 to 40% by mass with respect to the total amount of the glass fiber-reinforced resin composition.

Examples of the thermoplastic resin that forms the glass fiber-reinforced resin composition of the present embodiment can include the following: polyethylene, polypropylene, polystyrene, styrene/maleic anhydride resins, styrene/maleimide resins, polyacrylonitrile, acrylonitrile/styrene (AS) resins, acrylonitrile/butadiene/styrene (ABS) resins, chlorinated polyethylene/acrylonitrile/styrene (ACS) resins, acrylonitrile/ethylene/styrene (AES) resins, acrylonitrile/styrene/methyl acrylate (ASA) resins, styrene/acrylonitrile (SAN) resins, methacrylic resins, polyvinyl chloride (PVC), polyvinylidene chloride (PVDC), polyamide, polyacetal, polyethylene terephthalate (PET), polybutylene terephthalate (PBT), polytrimethylene terephthalate (PTT), polycarbonate, polyarylene sulfide, polyethersulfone (PES), polyphenylsulfone (PPSU), polyphenylene ether (PPE), modified polyphenylene ether (m-PPE), polyaryl etherketone, liquid crystal polymer (LCP), fluororesins, polyetherimide (PEI), polyarylate (PAR), polysulfone (PSF), polyamideimide (PAI), polyaminobismaleimide (PABM), thermoplastic polyimide (TPI), polyethylene naphthalate (PEN), ethylene/vinyl acetate (EVA) resins, ionomer (IO) resins, polybutadiene, styrene/butadiene resins, polybutylene, polymethylpentene, olefin/vinyl alcohol resins, cyclic olefin resins, cellulose resins, and polylactic acid.

Examples of the polyethylene can include high density polyethylene (HDPE), medium density polyethylene, low density polyethylene (LDPE), linear low density polyethylene (LLDPE), and ultra high molecular weight polyethylene.

Examples of the polypropylene can include isotactic polypropylene, atactic polypropylene, syndiotactic polypropylene, and mixtures thereof.

Examples of the polystyrene can include general-purpose polystyrene (GPPS), which is an atactic polystyrene having an atactic structure, high impact polystyrene (HIPS) with a rubber component added to GPPS, and syndiotactic polystyrene with syndiotactic structure.

Examples of the methacrylic resin can include polymers obtained by homopolymerizing one of acrylic acid, methacrylic acid, styrene, methyl acrylate, ethyl acrylate, ethyl methacrylate, butyl acrylate, butyl methacrylate, and fatty acid vinyl ester, or polymers obtained by copolymerizing two or more of these.

Examples of the polyvinyl chloride can include a vinyl chloride homopolymer, a copolymer of a vinyl chloride monomer and a copolymerizable monomer, or a graft copolymer obtained by graft polymerization of a vinyl chloride monomer to polymer polymerized by a conventionally known method such as emulsion polymerization method, suspension polymerization method, micro suspension polymerization method, or bulk polymerization method.

Examples of the polyamide can include one of the components such as polycaproamide (polyamide 6), polyhexamethylene adipamide (polyamide 66), polytetramethylene adipamide (polyamide 46), polytetramethylene sebacamide (polyamide 410), polypentamethylene adipamide (polyamide 56), polypentamethylene sebacamide (polyamide 510), polyhexamethylene sebacamide (polyamide 610), polyhexamethylene dodecamide (polyamide 612), polydecamethylene adipamide (polyamide 106), polydecamethylene sebacamide (polyamide 1010), polydecamethylene dodecamide (polyamide 1012), polyundecanamide (polyamide 11), polyundecamethylene adipamide (polyamide 116), polydodecanamide (polyamide 12), polyxylene adipamide (polyamide XD6), polyxylene sebacamide (polyamide XD10), polymetaxylylene adipamide (polyamide MXD6), polyparaxylylene adipamide (polyamide PXD6), polytetramethylene terephthalamide (polyamide 4T), polypentamethylene terephthalamide (polyamide 5T), polyhexamethylene terephthalamide (polyamide 6T), polyhexamethylene isophthalamide (polyamide 6I), polynonamethylene terephthalamide (polyamide 9T), polydecamethylene terephthalamide (polyamide 10T), polyundecamethylene terephthalamide (polyamide 11T), polydodecamethylene terephthalamide (polyamide 12T), polytetramethylene isophthalamide (polyamide 4I), polybis(3-methyl-4-aminohexyl) methane terephthalamide (polyamide PACMT), polybis(3-methyl-4-aminohexyl) methane isophthalamide (polyamide PACMI), polybis(3-methyl-4-aminohexyl) methane dodecamide (polyamide PACM12), and polybis(3-methyl-4-aminohexyl) methane tetradecamide (polyamide PACM14), or copolymers in which two or more multiple components are combined, or mixtures thereof.

Examples of the polyacetal can include a homopolymer with oxymethylene units as the main repeating unit, and a copolymer mainly consisting of oxymethylene units and containing oxyalkylene units having 2 to 8 adjacent carbon atoms in the main chain.

Examples of the polyethylene terephthalate can include a polymer obtained by polycondensation of terephthalic acid or a derivative thereof with ethylene glycol.

Examples of the polybutylene terephthalate can include a polymer obtained by polycondensation of terephthalic acid or a derivative thereof with 1,4-butanediol.

Examples of the polytrimethylene terephthalate can include polymers obtained by polycondensation of terephthalic acid or a derivative thereof with 1,3-propanediol.

Examples of the polycarbonate can include polymers obtained by a transesterification method in which a dihydroxydiaryl compound is reacted with a carbonate such as diphenyl carbonate in a molten state; or polymers obtained by phosgene method in which a dihydroxyaryl compound is reacted with phosgene.

Examples of the polyarylene sulfide can include linear polyphenylene sulfide, cross linked polyphenylene sulfide having a high molecular weight obtained by performing a curing reaction after polymerization, polyphenylene sulfide sulfone, polyphenylene sulfide ether, and polyphenylene sulfide ketone.

Examples of the modified polyphenylene ether can include: a polymer alloy of poly(2,6-dimethyl-1,4-phenylene) ether and polystyrene; a polymer alloy of poly(2,6-dimethyl-1,4-phenylene)ether and a styrene/butadiene copolymer; a polymer alloy of poly(2,6-dimethyl-1,4-phenylene)ether and a styrene/maleic anhydride copolymer; a polymer alloy of poly(2,6-dimethyl-1,4-phenylene)ether and polyamide; and a polymer alloy of poly(2,6-dimethyl-1,4-phenylene)ether and styrene/butadiene/acrylonitrile copolymer.

Examples of the polyaryl etherketone can include polyetherketone (PEK), polyetheretherketone (PEEK), polyetherketoneketone (PEKK), and polyetheretherketoneketone (PEEKK).

Examples of the liquid crystal polymer (LCP) include a polymer (copolymer) consisting of one or more structural units selected from aromatic hydroxycarbonyl units which are thermotropic liquid crystal polyesters, aromatic dihydroxy units, aromatic dicarbonyl units, aliphatic dihydroxy units, aliphatic dicarbonyl units, and the like.

Examples of the fluororesin can include polytetrafluoroethylene (PTFE), perfluoroalkoxy resins (PFA), fluorinated ethylene propylene resins (FEP), fluorinated ethylene tetrafluoroethylene resins (ETFE), polyvinyl fluoride (PVF), polyvinylidene fluoride (PVDF), polychlorotrifluoroethylene (PCTFE), and ethylene/chlorotrifluoroethylene resin (ECTFE).

Examples of the ionomer (IO) resin can include copolymers of an olefin or a styrene and an unsaturated carboxylic acid, wherein a part of carboxyl groups is neutralized with a metal ion.

Examples of the olefin/vinyl alcohol resin can include ethylene/vinyl alcohol copolymers, propylene/vinyl alcohol copolymers, saponified products of ethylene/vinyl acetate copolymers, and saponified products of propylene/vinyl acetate copolymers.

Examples of the cyclic olefin resin can include monocyclic compounds such as cyclohexene, polycyclic compounds such as tetracyclopentadiene, and polymers of cyclic olefin monomers.

Examples of the polylactic acid can include poly-L-lactic acid which is a homopolymer of L-form, poly-D-lactic acid which is a homopolymer of D-form, or a stereocomplex polylactic acid which is a mixture thereof.

Examples of the cellulose resin can include methylcellulose, ethyl cellulose, hydroxycellulose, hydroxymethylcellulose, hydroxyethyl cellulose, hydroxyethyl methylcellulose, hydroxypropylmethylcellulose, cellulose acetate, cellulose propionate, and cellulose butyrate. Also, examples of the thermosetting resin that forms the glass fiber-reinforced resin composition of the present embodiment can include the following: unsaturated polyester resins, vinyl ester resins, epoxy (EP) resins, melamine (MF) resins, phenol resins (PF), urethane resins (PU), polyisocyanate, polyisocyanurate, polyimide (PI), urea (UF) resins, silicone (SI) resins, furan (FR) resins, benzoguanamine (BR) resins, alkyd resins, xylene resins, bismaleimide triazine (BT) resins, diallyl phthalate resin (PDAP), and thermosetting polyphenylene ether resins.

Specific examples of the unsaturated polyester resin can include resin which can be obtained by esterification reaction of aliphatic unsaturated dicarboxylic acid and aliphatic diol.

Examples of the vinyl ester resin can include bis vinyl ester resins and novolac vinyl ester resins.

Examples of the epoxy resin can include bisphenol A epoxy resins, bisphenol F epoxy resins, bisphenol E epoxy resins, bisphenol S epoxy resins, bisphenol M epoxy resins (4,4'-(1,3-phenylenediisopropylidene)bisphenol epoxy resins), bisphenol P epoxy resins (4,4'-(1,4-phenylenediisopropylidene)bisphenol epoxy resins), bisphenol Z epoxy resins (4,4'-cyclohexylidene bisphenol epoxy resins), phenol novolac epoxy resins, cresol novolac epoxy resins, tetraphenol group ethane novolac type epoxy resins, novolac epoxy resins having a condensed ring aromatic hydrocarbon structure, biphenyl epoxy resins, aralkyl epoxy resins such as xylylene epoxy resins and phenyl aralkyl epoxy resins, naphthylene ether epoxy resins, naphthol epoxy resins, naphthalene diol epoxy resins, bifunctional or tetrafunctional epoxy naphthalene resins, binaphthyl epoxy resins, naphthalene aralkyl epoxy resins, anthracene epoxy resins, phenoxy epoxy resins, dicyclopentadiene epoxy resins, norbornene epoxy resins, adamantane epoxy resins, and fluorene epoxy resins.

Examples of the melamine resin can include a polymer formed by polycondensation of melamine (2,4,6-triamino-1,3,5-triazine) and formaldehyde.

Examples of the phenolic resin can include novolac phenolic resins such as phenol novolac resins, cresol novolac resins, and bisphenol A novolac resins, resol phenol resins such as methylol resole resins and dimethylene ether resole resins, or aryl alkylene phenol resins, and include one of these or combinations of two or more.

Examples of the urea resin can include a resin obtained by condensation of urea and formaldehyde.

The above thermoplastic resin or the above thermosetting resin may be used singly or in combinations of two or more.

Examples of the above other additives can include reinforcing fiber other than glass fiber (for example, carbon fiber, metal fiber), a filler other than glass fiber (for example, glass powder, talc, mica), a flame retardant, an UV absorber, a heat stabilizer, an antioxidant, an antistatic agent, a fluidity improver, an anti-blocking agent, a lubricant, a nucleating agent, an antibacterial agent, and a pigment.

The glass fiber-reinforced resin composition of the present embodiment can be obtained, for example, by kneading the chopped strands and the resin in a twin screw kneader and performing injection molding using the obtained resin pellets.

Also, the glass fiber-reinforced resin composition may be one obtained by using known molding methods such as injection compression molding method, two-color molding method, hollow molding method, foam molding method (including supercritical fluid foam molding method), insert molding method, in-mold coating molding method, extrusion molding method, sheet molding method, thermoforming method, rotational molding method, laminate molding method, press molding method, blow molding method, stamping molding method, infusion method, hand lay-up method, spray-up method, resin transfer molding method, sheet molding compound method, bulk molding compound method, pultrusion method, and filament winding method.

Also, the glass fiber-reinforced resin composition of the present embodiment may be prepreg obtained by impregnating the glass fiber woven fabric of the present embodiment with the resin by a known method per se and semi-curing the woven fabric.

Examples of applications of molded products formed from the glass fiber-reinforced resin composition of the present embodiment can include electronic device housing, electronic components, vehicle exterior members, vehicle interior members, vehicle engine members, muffler related members, high pressure tanks, and composite materials for wind energy.

Examples of the electronic components include printed circuit boards.

Examples of the vehicle exterior members include bumpers, fenders, bonnets, air dams, and wheel covers.

Examples of the vehicle interior members include door trims and ceiling materials.

Examples of the vehicle engine members include oil pans, engine covers, intake manifolds, and exhaust manifolds.

Examples of the muffler members include silencers.

Examples of the composite materials for wind energy can include wind turbine blades.

The glass fiber of the present embodiment can be suitably used as a reinforcing material for inorganic materials such as gypsum and cement, in addition to the glass fiber-reinforced resin composition of the present embodiment. For example, when used as a reinforcing material for gypsum, especially, gypsum board having a thickness in the range of 4 to 60 mm, the glass fiber comprising the glass composition in the above range can be included in a range of 0.1 to 4.0% by mass with respect to the total mass of gypsum.

Examples and Comparative Examples of the present invention will be shown.

Examples

[Examples 1 to 12 and Comparative Examples 1 to 6]

For the respective glass batches prepared to have the compositional feature of the glass compositions for glass fiber of Examples 1 to 12 and Comparative Examples 1 to 6 shown in Tables 1 to 3, measurements of the elastic modulus, the coefficient of linear thermal expansion, the dielectric constant, and the dielectric loss tangent were performed by the following measurement methods, and the clarity of the molten glass and the compositional uniformity of the molten glass were evaluated by the following evaluation methods. The results are shown in Tables 1 to 3.

Note that Comparative Example 3 has the same compositional feature as that of Example 1 in PCT/JP2023/014110, and Comparative Example 4 has the same compositional feature as that of Example 2 in Japanese Patent Application No. 2023-029848.

Also, the glass fiber obtained from the glass composition for glass fiber of Example 1 had an elastic modulus of 82.6 GPa, a coefficient of linear thermal expansion of 2.2 ppm/K, a dielectric constant at 10 GHz of 4.7, a dielectric loss tangent at 10 GHz of 0.0043, a dielectric constant at 28 GHz of 4.6, a dielectric loss tangent at 28 GHz of 0.0057, a dielectric loss tangent at 56 GHz of 4.6, and a dielectric loss tangent at 56 GHz of 0.0071, and the molten glass obtained from the composition had a clarity of "A" and a compositional uniformity of 0.6%.

[Measurement method of elastic modulus]

First, a glass batch adjusted to have the compositional feature of the glass composition for glass fiber is placed in an 80 mm diameter platinum crucible, melted by heating at a temperature of 1650°C for 6 hours, and then taken out of the platinum crucible to obtain homogeneous glass bulk or glass cullet. The obtained glass bulk or glass cullet is then annealed by heating at a temperature of 750°C for 8 hours to obtain a test piece. Next, the test piece is processed into a test piece for elastic modulus measurement of 50 mm × 50 mm × 5 mm using a cutting machine such as diamond cutter and a polisher, and using the test piece for elastic modulus measurement, the elastic modulus is measured by the ultrasonic pulse method according to JIS R 1602:1995.

[Measurement method of coefficient of linear thermal expansion]

First, a test piece obtained in the same manner as in the case of the elastic modulus measurement described above is processed into a test piece for coefficient of linear thermal expansion measurement of 4 mm × 4 mm × 20 mm using a cutting machine such as diamond cutter and a polisher. Next, the obtained test piece for coefficient of linear thermal expansion measurement is heated at a temperature increase rate of 10°C/min, and the amount of elongation is measured using a coefficient of thermal expansion measuring apparatus (manufactured by NETZSCH, trade name: DIL 402) in the range of 50 to 200°C. From the amount of elongation, the coefficient of linear thermal expansion is calculated.

[Evaluation method of clarity]

First, a glass batch adjusted to have the compositional feature of the glass composition for glass fiber is placed in an 80 mm diameter platinum crucible, melted at a temperature of 1600°C for 3 hours, and then taken out of the platinum crucible to obtain glass bulk. The obtained glass bulk is heated at a temperature of 750°C for 2 hours, and then annealed by cooling to room temperature over 8 hours to obtain a test piece. Next, the central part of the obtained test piece is cut out to a size of 10 mm × 15 mm using a cutting machine such as diamond cutter, and the surface is polished with #2000 abrasive paper. The number of bubbles included in the test piece whose surface has been polished is then measured using an optical microscope, and those in which the number of bubbles per 1 g of glass bulk is less than 150 are evaluated as "A", those in which the number of bubbles is 150 or more and less than 1000 are evaluated as "B", and those in which the number of bubbles is 1000 or more are evaluated as "C".

[Evaluation method of compositional uniformity]

First, the central part of a test piece obtained in the same manner as for the evaluation method of clarity is cut out to a size of 10 mm × 15 mm for the top and bottom surfaces using a cutting machine such as diamond cutter, and the surface is polished with #2000 abrasive paper. Next, for the sides of the test piece whose surface has been polished, compositional analysis is performed by the EDS (energy dispersive spectroscopy) to evaluate the difference in compositional feature between the top and bottom regions. Specifically, using a field emission scanning electron microscope (FE-SEM, manufactured by JEOL Ltd., model number: JSM-IT800) and an energy dispersive spectrometer (manufactured by JEOL Ltd., model number: EDS 30 mm$^2$ detector), an area measurement is performed for a region of 1 mm in height range from each of the top and bottom surfaces, with an arbitrary field of view of 100 μm$^2$ or more, to measure the content (%) in terms of oxide for each element included in the glass composition for glass fiber. Note that the measurement of the content in terms of oxide for the element is carried out in three different areas for each of the top and bottom regions, and the average value of the measurement results for the three areas is used as the content in terms of oxide for each element. For each element, the absolute value of the difference between the content in terms of oxide in the top region and the content in terms of oxide in the bottom region is calculated, and the calculation is performed for all elements detected. The value obtained by adding up the absolute values of the differences in content of all of the elements is used as the compositional uniformity. Note that a smaller value for the compositional uniformity means a smaller variation in compositional feature of the molten glass (excellent uniformity).

[Measurement method of dielectric constant and dielectric loss tangent]

For the dielectric constant (dielectric constant Dk) and dielectric loss tangent (dissipation factor Df) at 10 GHz or less, first, the test piece is polished to prepare an 80 mm × 3 mm (1 mm thickness) polished test piece. Then, the obtained polished test piece is completely dried and then stored in a room at 23°C and a humidity of 60% for 24 hours. Subsequently, for the obtained polished test piece, according to JIS C 2565: 1992, the dielectric constant (dielectric constant Dk) and dielectric loss tangent (dissipation factor Df) at 10 GHz are measured using ADMS01Oc1 (trade name), a cavity resonator method dielectric constant measuring apparatus manufactured by AET, Inc.

For the dielectric constant (dielectric constant Dk) and dielectric loss tangent (dissipation factor Df) at more than 10 GHz, first, the test piece is polished to prepare a 37 mm × 37 mm (0.3 mm thickness) polished test piece. Then, the obtained polished test piece is completely dried and then stored in a room at 25°C and a humidity of 50% for 24 hours. Subsequently, for the obtained polished test piece, the dielectric constant (dielectric constant Dk) and dielectric loss tangent (dissipation factor Df) at 28 GHz and 56 GHz are measured by the balanced-type circular disk resonator method.

[Table 1]

|  | Example 1 | Example 2 | Example 3 | Example 4 | Example 5 | Example 6 |
|---|---|---|---|---|---|---|
| $SiO_2$ (% by mass) | 50.26 | 55.49 | 45.45 | 50.15 | 51.43 | 56.46 |
| $Al_2O_3$ (% by mass) | 25.33 | 28.25 | 21.17 | 24.08 | 25.21 | 18.55 |
| MgO (% by mass) | 3.02 | 5.01 | 0.20 | 3.51 | 4.02 | 0.00 |
| CaO (% by mass) | 0.00 | 0.00 | 0.00 | 0.00 | 0.00 | 2.51 |
| ZnO (% by mass) | 7.04 | 4.00 | 13.10 | 10.03 | 6.05 | 16.04 |
| $TiO_2$ (% by mass) | 0.50 | 0.00 | 1.17 | 0.00 | 0.00 | 0.00 |
| $P_2O_5$ (% by mass) | 10.64 | 6.87 | 13.83 | 9.83 | 5.93 | 3.93 |
| $Fe_2O_3$ (% by mass) | 0.45 | 0.10 | 0.04 | 0.75 | 1.00 | 0.01 |
| $SnO_2$ (% by mass) | 0.05 | 0.10 | 0.50 | 0.75 | 0.01 | 0.69 |
| $B_2O_3$ (% by mass) | 2.71 | 0.18 | 4.54 | 0.90 | 6.35 | 1.81 |
| $Li_2O+Na_2O+K_2O$ (% by mass) | 0.00 | 0.00 | 0.00 | 0.00 | 0.00 | 0.00 |
| $MnO_2$ | 0.00 | 0.00 | 0.00 | 0.00 | 0.00 | 0.00 |
| $CeO_2$ | 0.00 | 0.00 | 0.00 | 0.00 | 0.00 | 0.00 |
| MxOy (% by mass) | 0.50 | 0.20 | 0.54 | 1.50 | 1.01 | 0.70 |
| $(Z/P) \times M^{1/2}$ | 0.468 | 0.260 | 0.696 | 1.250 | 1.025 | 3.415 |
| $SnO_2/Fe_2O_3$ | 0.11 | 1.00 | 12.50 | 1.00 | 0.01 | 69.00 |
| Total (% by mass) | 100.00 | 100.00 | 100.00 | 100.00 | 100.00 | 100.00 |
| Clarity | A | A | A | A | A | A |
| Compositional uniformity (%) | 0.6 | 1.8 | 4.2 | 3.4 | 7.1 | 8.8 |
| Elastic modulus (GPa) | 82.6 | 91.1 | 74.8 | 84.8 | 82.4 | 83.6 |
| Coefficient of linear thermal expansion (ppm/K) | 2.2 | 2.3 | 2.1 | 2.3 | 2.5 | 2.4 |

[Table 2]

|  | Example 7 | Example 8 | Example 9 | Example 10 | Example 11 | Example 12 |
|---|---|---|---|---|---|---|
| $SiO_2$ (% by mass) | 53.07 | 61.12 | 64.05 | 43.53 | 53.07 | 53.07 |
| $Al_2O_3$ (% by mass) | 19.53 | 12.07 | 14.81 | 29.22 | 19.53 | 19.53 |
| MgO (% by mass) | 0.00 | 5.03 | 5.00 | 6.05 | 0.00 | 0.00 |
| CaO (% by mass) | 0.00 | 0.00 | 0.00 | 0.00 | 0.00 | 0.00 |
| ZnO (% by mass) | 20.03 | 10.27 | 9.02 | 2.12 | 20.03 | 20.03 |
| $TiO_2$ (% by mass) | 0.00 | 0.00 | 2.00 | 0.00 | 0.00 | 0.00 |
| $P_2O_5$ (% by mass) | 6.37 | 5.23 | 3.92 | 14.32 | 6.37 | 6.37 |
| $Fe_2O_3$ (% by mass) | 0.40 | 0.75 | 0.50 | 0.50 | 0.00 | 0.00 |
| $SnO_2$ (% by mass) | 0.60 | 1.00 | 0.50 | 0.00 | 0.00 | 0.00 |
| $B_2O_3$ (% by mass) | 0.00 | 4.53 | 0.00 | 4.26 | 0.00 | 0.00 |

(continued)

|  | Example 7 | Example 8 | Example 9 | Example 10 | Example 11 | Example 12 |
|---|---|---|---|---|---|---|
| $Li_2O+Na_2O+K_2O$ (% by mass) | 0.00 | 0.00 | 0.20 | 0.00 | 0.00 | 0.00 |
| $MnO_2$ | 0.00 | 0.00 | 0.00 | 0.00 | 1.00 | 0.00 |
| $CeO_2$ | 0.00 | 0.00 | 0.00 | 0.00 | 0.00 | 1.00 |
| MxOy (% by mass) | 1.00 | 1.75 | 1.00 | 0.50 | 1.00 | 1.00 |
| $(Z/P) \times M^{1/2}$ | 3.144 | 2.598 | 2.301 | 0.105 | 3.144 | 3.144 |
| $SnO_2/Fe_2O_3$ | 1.50 | 1.33 | 1.00 | 0.00 | Not calculable | Not calculable |
| Total (% by mass) | 100.00 | 100.00 | 100.00 | 100.00 | 100.00 | 100.00 |
| Clarity | A | B | B | B | B | B |
| Compositional uniformity (%) | 8.6 | 2.4 | 3.8 | 1.4 | 9.4 | 9.3 |
| Elastic modulus (GPa) | 85.0 | 76.2 | 84.8 | 82.8 | 84.8 | 85.2 |
| Coefficient of linear thermal expansion (ppm/K) | 2.2 | 2.5 | 2.5 | 2.5 | 2.3 | 2.3 |

[Table 3]

|  | Comparative Example 1 | Comparative Example 2 | Comparative Example 3 | Comparative Example 4 | Comparative Example 5 | Comparative Example 6 |
|---|---|---|---|---|---|---|
| $SiO_2$ (% by mass) | 63.04 | 53.74 | 56.00 | 52.50 | 45.50 | 43.06 |
| $Al_2O_3$ (% by mass) | 16.22 | 20.17 | 22.50 | 24.00 | 20.22 | 25.04 |
| MgO (% by mass) | 0.00 | 3.02 | 0.00 | 2.50 | 5.06 | 0.00 |
| CaC (% by mass) | 0.00 | 0.00 | 0.00 | 0.00 | 2.02 | 0.00 |
| ZnO (% by mass) | 15.51 | 2.52 | 17.50 | 8.50 | 0.00 | 30.05 |
| $TiO_2$ (% by mass) | 0.00 | 0.00 | 0.00 | 0.00 | 0.81 | 0.00 |
| $P_2O_5$ (% by mass) | 4.22 | 15.81 | 4.00 | 10.00 | 19.82 | 0.00 |
| $Fe_2O_3$ (% by mass) | 1.00 | 0.20 | 0.00 | 0.00 | 0.10 | 0.30 |
| $SnO_2$ (% by mass) | 0.01 | 0.00 | 0.00 | 0.00 | 0.10 | 0.20 |
| $B_2O_3$ (% by mass) | 0.00 | 4.54 | 0.00 | 2.50 | 6.37 | 1.35 |
| $Li_2O+Na_2O+K_2O$ (% by mass) | 0.00 | 0.00 | 0.00 | 0.00 | 0.00 | 0.00 |
| $MnO_2$ | 0.00 | 0.00 | 0.00 | 0.00 | 0.00 | 0.00 |
| $CeO_2$ | 0.00 | 0.00 | 0.00 | 0.00 | 0.00 | 0.00 |
| MxOy (% by mass) | 1.01 | 0.20 | 0.00 | 0.00 | 0.20 | 0.50 |
| $(Z/P) \times M^{1/2}$ | 3.694 | 0.071 | 0.000 | 0.000 | 0.000 | Not calculable |

(continued)

|  | Comparative Example 1 | Comparative Example 2 | Comparative Example 3 | Comparative Example 4 | Comparative Example 5 | Comparative Example 6 |
|---|---|---|---|---|---|---|
| $SnO_2/Fe_2O_3$ | 0.01 | 0.00 | Not calculable | Not calculable | 1.00 | 0.67 |
| Total (% by mass) | 100.00 | 100.00 | 100.00 | 100.00 | 100.00 | 100.00 |
| Clarity | C | C | C | C | B | A |
| Compositional uniformity (%) | 10.2 | 5.0 | 19.4 | 17.0 | 0.6 | 14.6 |
| Elastic modulus (GPa) | 82.2 | 71.7 | 88.6 | 83.4 | 69.2 | 96.5 |
| Coefficient of linear thermal expansion (ppm/K) | 2.0 | 1.8 | 2.2 | 2.1 | 2.4 | 3.1 |

From Tables 1 and 2, according to the glass compositions for glass fiber of Examples 1 to 10, which include $SiO_2$ in the range of 42.00 to 70.00% by mass, $Al_2O_3$ in the range of 10.00 to 30.00% by mass, MgO in the range of 0.00 to 8.00% by mass, CaO in the range of 0.00 to 5.00% by mass, ZnO in the range of 2.00 to 25.00% by mass, $TiO_2$ in the range of 0.00 to 5.00% by mass, $P_2O_5$ in the range of 2.00 to 17.30% by mass, and MxOy in the range of 0.01 to 2.00% by mass in total, with respect to the total amount, in which the content Z of ZnO, the content P of $P_2O_5$, and the content M of MxOy satisfy the above formula (1), it is clear that both a high elastic modulus and a low coefficient of linear thermal expansion can be achieved, that the clarity of the molten glass can be increased, and that the compositional feature of the molten glass can be uniform.

On the other hand, from Table 3, according to the glass composition for glass fiber of Comparative Example 1, in which the value of $(Z/P) \times M^{1/2}$ is more than 3.554 and outside the range of the above formula (1), it is clear that the clarity is low and the compositional feature of the molten glass cannot be uniform. Also, according to the glass composition for glass fiber of Comparative Example 2, in which the value of $(Z/P) \times M^{1/2}$ is less than 0.088 and outside the range of the above formula (1), it is clear that the clarity is low. In addition, according to the glass compositions for glass fiber of Comparative Example 3 and Comparative Example 4, in which the content of MxOy is 0.00%, it is clear that the clarity is low and the compositional feature of the molten glass cannot be uniform. Moreover, according to the glass composition for glass fiber of Comparative Example 5, in which the content of ZnO is 0.00%, it is clear that the glass fiber cannot have a high elastic modulus. Furthermore, according to the glass composition for glass fiber of Comparative Example 6, in which the content of $P_2O_5$ is 0.01%, it is clear that the glass fiber cannot have a low coefficient of linear thermal expansion.

**Claims**

1. A glass composition for glass fiber, comprising:

$SiO_2$ in a range of 42.00 to 70.00% by mass,
$Al_2O_3$ in a range of 10.00 to 30.00% by mass,
MgO in a range of 0.00 to 8.00% by mass,
CaO in a range of 0.00 to 5.00% by mass,
ZnO in a range of 2.00 to 25.00% by mass,
$TiO_2$ in a range of 0.00 to 5.00% by mass,
$P_2O_5$ in a range of 2.00 to 17.30% by mass, and
MxOy, which is at least one or more oxides selected from a group consisting of $Fe_2O_3$, $SnO_2$, $CeO_2$, $MnO_2$, $Sb_2O_3$, and $As_2O_3$, in a range of 0.01 to 2.00% by mass in total, with respect to the total amount,
wherein a content Z of ZnO, a content P of $P_2O_5$, and a content M of MxOy satisfy a following formula (1):

$$0.088 \leq (Z/P) \times M^{1/2} \leq 3.554 \ ... \ (1).$$

2. The glass composition for glass fiber according to claim 1, wherein a content Z of ZnO, a content P of $P_2O_5$, and a content M of MxOy satisfy a following formula (2):

$$0.183 \leq (Z/P) \times M^{1/2} \leq 1.775 \ldots (2).$$

3. The glass composition for glass fiber according to claim 2, comprising:

   $Fe_2O_3$ in a range of 0.01 to 2.00% by mass, and
   $SnO_2$ in a range of 0.01 to 2.00% by mass,
   wherein a content F of $Fe_2O_3$ and a content S of $SnO_2$ satisfy a following formula (3):

$$0.06 \leq S/F \leq 40.75 \ldots (3).$$

4. The glass composition for glass fiber according to claim 1, wherein a content Z of ZnO, a content P of $P_2O_5$, and a content M of MxOy satisfy a following formula (4):

$$0.183 \leq (Z/P) \times M^{1/2} \leq 0.582 \ldots (4).$$

5. Glass fiber comprising a glass filament formed from the glass composition for glass fiber according to claim 1.

6. A glass fiber woven fabric comprising the glass fiber according to claim 5.

7. A glass fiber-reinforced resin composition comprising the glass fiber according to claim 5.

# EP 4 620 931 A1

## INTERNATIONAL SEARCH REPORT

| | International application No. |
|---|---|
| | **PCT/JP2024/025082** |

### A. CLASSIFICATION OF SUBJECT MATTER

*C03C 13/00*(2006.01)i; *B29B 15/08*(2006.01)i; *C03C 3/097*(2006.01)i; *H05K 1/03*(2006.01)i; *B29K 105/06*(2006.01)n
FI: C03C13/00; B29B15/08; C03C3/097; H05K1/03 610T; B29K105:06

According to International Patent Classification (IPC) or to both national classification and IPC

### B. FIELDS SEARCHED

Minimum documentation searched (classification system followed by classification symbols)

C03C13/00; B29B15/08; C03C3/097; H05K1/03; B29K105/06

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

INTERGLAD

### C. DOCUMENTS CONSIDERED TO BE RELEVANT

| Category* | Citation of document, with indication, where appropriate, of the relevant passages | Relevant to claim No. |
|---|---|---|
| A | WO 2023/276618 A1 (NITTO BOSEKI CO., LTD.) 05 January 2023 (2023-01-05) entire text | 1-7 |
| A | WO 2023/127220 A1 (NITTO BOSEKI CO., LTD.) 06 July 2023 (2023-07-06) entire text | 1-7 |
| A | WO 2023/276619 A1 (NITTO BOSEKI CO., LTD.) 05 January 2023 (2023-01-05) entire text | 1-7 |
| A | WO 2022/181340 A1 (NITTO BOSEKI CO., LTD.) 01 September 2022 (2022-09-01) entire text | 1-7 |
| A | JP 2022-079402 A (TAIWAN GLASS INDUSTRY CORP.) 26 May 2022 (2022-05-26) entire text | 1-7 |
| P, A | JP 7436946 B1 (NITTO BOSEKI CO., LTD.) 22 February 2024 (2024-02-22) entire text | 1-7 |

☐ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **27 August 2024** | **10 September 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/025082**

| Patent document cited in search report | Publication date (day/month/year) | Patent family member(s) | Publication date (day/month/year) |
|---|---|---|---|
| WO 2023/276618 A1 | 05 January 2023 | US 2023/0399252 A1 entire text<br>EP 4249445 A1<br>KR 10-2023-0108733 A<br>CN 117529456 A | |
| WO 2023/127220 A1 | 06 July 2023 | EP 4371955 A1 entire text<br>KR 10-2024-0049568 A | |
| WO 2023/276619 A1 | 05 January 2023 | EP 4299541 A1 entire text<br>CN 117545727 A<br>KR 10-2024-0026881 A | |
| WO 2022/181340 A1 | 01 September 2022 | US 2023/0373849 A1 entire text<br>EP 4299540 A1<br>CN 116670091 A<br>KR 10-2023-0148319 A<br>JP 2022-129395 A<br>JP 7111283 B1 | |
| JP 2022-079402 A | 26 May 2022 | US 2022/0153628 A1 entire text | |
| JP 7436946 B1 | 22 February 2024 | WO 2023/228594 A1 entire text<br>KR 10-2024-0074919 A | |

Form PCT/ISA/210 (patent family annex) (July 2022)

**REFERENCES CITED IN THE DESCRIPTION**

**Patent documents cited in the description**

- JP 2023029848 A

- JP 2023014110 W